# EUROPEAN PATENT SPECIFICATION

(11) **EP 0 667 962 B1**
(45) Date of publication and mention of the grant of the patent: **24.04.1996**
(21) Application number: 93912939.1
(22) Date of filing: 09.06.1993
(51) Int. Cl.: G01R 1/073

(54) **PRINTED CIRCUIT BOARD TESTING DEVICE WITH FOIL ADAPTER**
TESTANORDNUNG MIT FILMADAPTOR FUER LEITERPLATTEN
DISPOSITIF POUR TESTER DES PLAQUETTES A CIRCUITS IMPRIMES AVEC UN ADAPTATEUR A FEUILLE

(30) Priority: 06.11.1992 DE 4237591
(43) Date of publication of application: 23.08.1995
(73) Proprietor: MANIA GmbH & Co., D-61276 Weilrod (DE)
(72) Inventor: MANG, Paul, D-6384 Schmitten 3 (DE); DRILLER, Hubert, D-6384 Schmitten (DE)
(74) Representative: Ruschke, Hans Edvard, Dipl.-Ing.
(86) International application number: EP9301468
(87) International publication number: WO9411743

(56) References cited:
- EP-A- 0 144 682
- EP-A- 0 184 619
- WO-A-86/00173
- DE-U- 8 809 592

## Description

### Printed Circuit Board Testing Device with foil adapter

This invention concerns a printed circuit board testing device with an adapter or a contact arrangement for connecting the regular basic grid of an electronic testing device for single-layer or multi-layer, board-type wiring planes, such as printed circuit boards, ceramic substrates and the like, to the not necessarily grid-orientated contacts/connecting points of the wiring plane (test specimen) to be tested, which are in the form of metallic contact areas or connecting holes on one or both surfaces of the test specimen. In the test being discussed here, the wiring planes are not usually fitted with active electrical/electronic components, except where an IC or the like is being tested. In this connection it should be pointed out that the printed circuit board testing devices in question can be used for testing one side or both sides of printed circuit boards.

Many different versions of such contact arrangements - frequently referred to as "adapters" or "test jigs" - are known *inter alia* from the literature "Patent Abstracts of Japan", Vol. 7, No. 278 (P-242) (1423), 10th December 1983 and JP-A-58 155 374 dated 16.9.1983, or from IBM Technical Disclosure Bulletin, Vol. 24, No. 7A, Dec. 1981, pages 3342 to 3344. Further such arrangements are known from GB-A-2 156 532, US-A-4 099 120 and US-4-443 756.

Furthermore, EP 184 619 B1 shows a printed circuit board testing device which has a basic contact grid with an "active basic grid" arranged upon it, which consists of spring test pins or contacts arranged in accordance with the basic contact grid in an insulating basic grid body, onto which a rigid adapter plate is laid, which compensates for local, increased connection densities on the test specimen and/or the lateral displacement (in the X and Y directions of this plate) between the regularly-arranged contacts of the basic grid and the not necessarily regularly-arranged contacts of the printed circuit board (test specimen) to be tested. This is achieved by arranging contact areas on one side of the adapter plate in accordance with the basic grid, whereas on the other side of this adapter plate the arrangement of contact areas assigned to the test specimen is identical to that of the test specimen, whereby printed conductors and plated-through holes on and in the plate, respectively, provide the connection between the mutually-related contact areas of the adapter plate. In turn, vertically-arranged test probes, spring-loaded in their longitudinal direction, against whose points the contact areas of the test specimen are pressed by a suitable pressure-contact device, then make contact with the contact areas of the adapter plate corresponding to the test specimen. Instead of these last-named test probes, a further embodiment of this EP 184 619 B1 provides a "vertical conducting plate" that conducts current only perpendicularly to the plane of the plate. Both this elastically-compressible, vertical conducting plate and the spring test probes between the rigid adapter plate, which make contact with the test specimen, are necessary in order to produce the individual contact pressure required at each contact point for good contact.

In the first embodiment of this previously known arrangement, it is a disadvantage that, apart from the need for the adapter to be manufactured individually according to usual printed circuit techniques anyway, a large number of spring test probes is also required, the provision of which represents a considerable investment for the user of the test equipment, since these test probes are required in really large numbers. In addition, due to the necessary mechanical strength of such spring test probes, limits are placed on their miniaturization and thus the permissible density of the contacts or test probes.

These previously known problems are partially remedied in the claimed further embodiment of EP 184 619 B1 in that the contact between the side of the adapter plate facing the test specimen and the test specimen itself is effected by the vertical conducting plate, which in principle consists of a mat of elastic, insulating material within which finely distributed contact wires run parallel to each other, perpendicular to the mat, and are thus insulated from each other, and which project at the top and bottom from the surface of the vertical conducting plate. The adapter plate and the test specimen can certainly be connected comparatively easily with the aid of such vertical conducting plates, but the manufacture of such vertical conducting plates is extremely extensive, added to which the use of such a contacting technique could be impeded by patents or the like in existence in various countries. Furthermore, these vertical conducting plates have only a limited life if they are always repeatedly loaded by the contact pressure required for making contact with the test specimens. Due to the continuously repeated bending load, particularly on the ends of the contact wires projecting at the surface of the vertical conducting plate, these break off and gradually lead to the failure of the vertical conducting plate.

An adapter arrangement without test probes for testing devices of the type discussed here is shown in the applicant's EP 369 112 A1. Here, the necessary spring compliance for producing the required contact pressure at each test point of the test specimen is obtained in an embodiment in that a compressible plug of electrically-conductive elastomer is arranged on the essentially rigid adapter plate on each contact area. In a further embodiment described in this publication, this contact pressure is produced at each test point of the test specimen by constructing the adapter plate itself as a thin, flexible foil whose test specimen-specific contact areas are placed directly onto the test point of the test specimen and, incidentally, on the side facing away from the test specimen is pressed in the direction of the test specimen by a spring contact arrangement.

This previously known adapter arrangement, at least in the above-mentioned further embodiment, for the first time facilitates direct contact between the adapter foil and the test specimen by removing the means for producing the individual contact pressure at each test point of the test specimen from the area between the test specimen and the adapter plate or adapter foil, respectively. Since the conductive elastomer test probes or plugs with their limited miniaturization capability, or the known vertical conducting plate with its drawbacks as discussed, no longer have to be inserted in the area between the adapter plate or adapter foil, respectively, and the test specimen, after the adapter foil is placed with its test specimen-specific contact areas directly onto the test points of the printed circuit board to be tested, there are promising possibilities for increasing the density of test points which can be tested with an adapter arrangement. But in this adapter technique, which is based on direct contact between a flexible adapter foil and the test specimen in an adapter that is not hard-wired, practical difficulties are soon encountered with greatly increased miniaturization. This is especially true if, as in many current, conventional SMD wiring planes or printed circuit boards, the centre-to-centre distance between adjacent test points is only 0.2 mm and their area is approximately 0.1 x 0.5 mm. With such small test points and test point spacings on the test specimen or the test specimen-specific contact areas on the adapter foil, this can lead to contact faults which are entirely due to manufacturing length tolerances in the test specimens or the adapter foil.

These problems are solved by this invention, in that the adapter foil and the printed circuit boards to be tested are retained in the adapter arrangement, with the foil and the circuit board being displaceable relative to each other in or parallel to the plane of the adapter foil to connect the circuit board with the adapter foil in order to adjust the adapter foil as required so that the contact faults which are entirely due to manufacturing length tolerances in the test specimens or adpater foil disappear. Alternatively, displacement of the printed circuit board relative to the foil is also possible. In this connection, it can also be advantageous to elongate or stretch the adapter foil elastically in addition.

The preferably, regularly-arranged lands of the adapter foil that face the basic grid are, advantageously, made considerably larger than the possibly very small and possibly locally very densely arranged test specimen-specific lands on the side of the adapter foil facing the test specimen. Consequently, contact between the part of the adapter arrangement arranged between the adapter foil and the basic grid is not then lost if the foil is displaced or stretched by an amount which corresponds to the size of the test specimen-specific lands.

The adapter arrangement according to the invention is especially suitable for printed circuit board test equipment that is set up to test both sides of a printed circuit board simultaneously, because local, mechanical overstressing of the printed circuit board can be reliably avoided by means of the uniformly distributed support provided for all areas of the printed circuit board by the flexible adapter foil which is being supported on its backside by a continuous pressure transmitting part of elastically-compressible insulating material. A further contributory factor is that where the adapter foil makes contact with the side facing away from the test specimen by means of a conventional test probe adapter, the contact areas are preferably regularly arranged. Furthermore, this conventional test probe adapter connection technique avoids so-called "footprints" or impressions of the probes in the test points of the test specimen with which contact is to be made.

The attached drawings show schematic representations of two practical examples of the present invention. These are:
- Fig. 1: a printed circuit board testing device with the adapter arrangement according to the invention in an arrangement without test probes;
- Fig. 2: the printed circuit board testing device with the adapter arrangement according to the invention in conjunction with a conventional test probe adapter;
- Fig. 3: a schematic, fragmented, exploded view of the arrangement similar to Fig. 1;
- Fig. 4: a schematic, fragmented, exploded view of an arrangement similar to Fig. 2;
- Fig. 5: a perspective, fragmented representation of an adapter foil employed in the application; and
- Fig. 6: a perspective, schematic representation of the displacement and stretching possibilities of the adapter foil according to the invention.

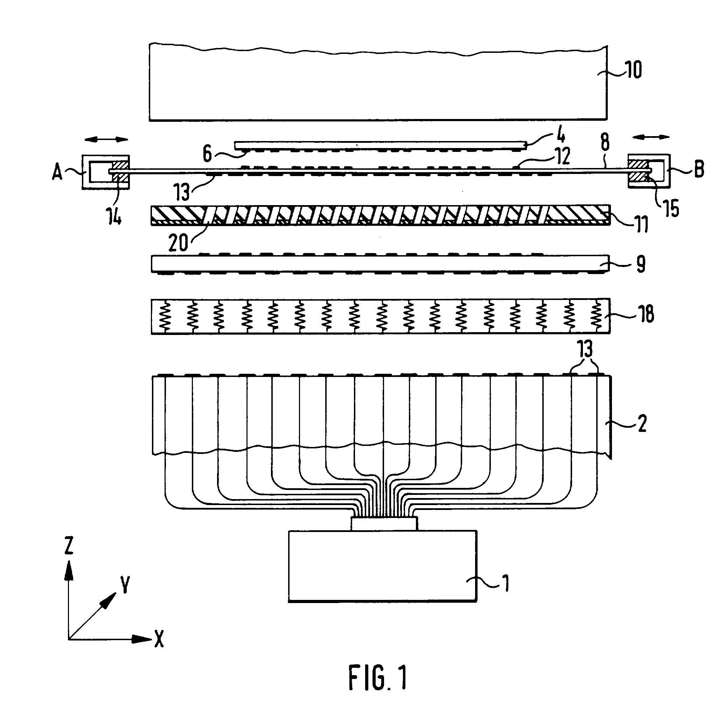

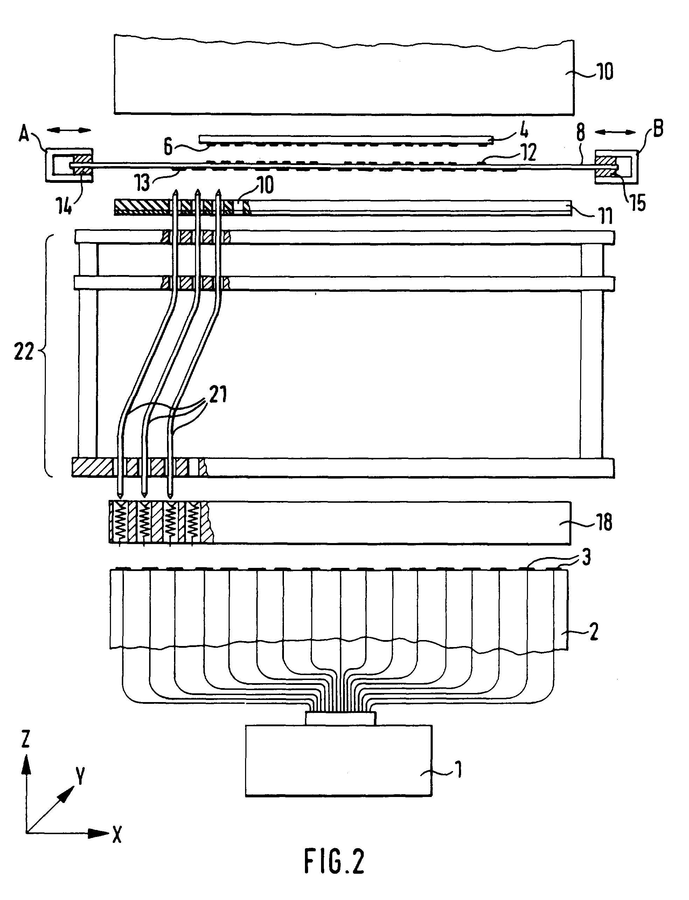

Figures 1 and 2 show in one representation two different embodiments of the printed circuit board testing device according to the invention, in which the individual elements are separated from each other in the vertical direction, i.e. in the direction of the Z-axis of the coordinate system shown, in order to show the relationships better. It should also be noted that the elements represent a three-dimensional object, whereby the representation is only in the X-Z plane, i.e. the plane of the drawing, and the third dimension - the Y coordinate perpendicular to the plane of the drawing - is not shown.

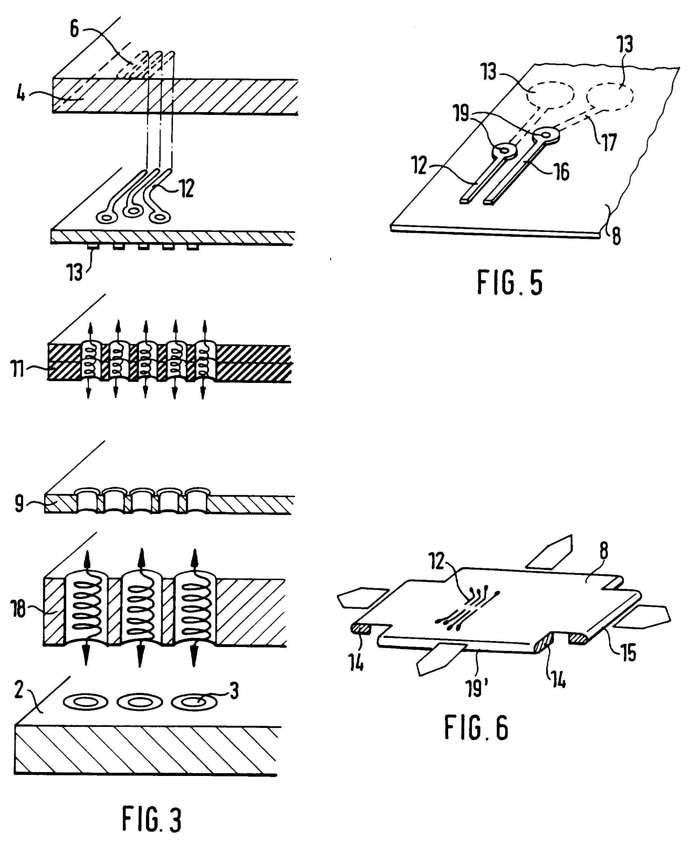

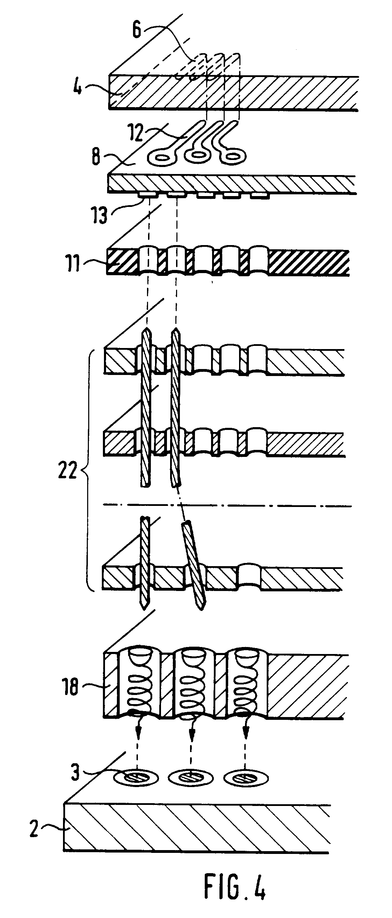

Reference numeral 2 denotes a printed circuit board tester, which is usually connected to a computer 1, with a regular basic grid 3 of contact points to connect the non grid-orientated test points or connecting points 6 of the test specimen 4 with the aid of the adapter technique which will be described below. As is usual in the printed circuit board industry, the connecting points 6 on the wiring plane 4 (printed circuit board, ceramic substrate, etc.) are arranged in practically any way, i.e. they can for example be arranged to be partially grid-orientated and/or partially tightly packed locally, etc. on the printed circuit board 4 to be tested, and frequently in fact with many hundreds or even thousands of test points/connection points 6 per printed circuit board/ wiring plane 4. In order to connect these irregularly-arranged connection points to the regularly-arranged contacts of the basic grid 3 of the testing device 2, a flexible adapter foil 8 is provided, which, in accordance with the usual printed circuit board techniques, has to be manufactured as an individual printed circuit with contact areas or lands 12 and 13 on both sides of the adapter foil. Here the lands 13 facing the testing device 2 are arranged either exactly according to the basic grid 3 of the testing device, or in an intermediate grid which preferably is as regular as and/or more densely packed than the basic grid 3, on which a further conversion with known suitable adapter techniques (adapter plate 9, active basic grid 18) takes place, whereas the contact areas 12 on the side of the adapter foil 8 facing the test specimen are distributed according to the arrangement of test points or connecting points 6 of the test specimen 4. In this case each land 12 is connected to a corresponding land 13 on the other side of the adapter foil 8, i.e. according to usual printed circuit board techniques, with the aid of printed conductors 16, 17 on one of the two surfaces of the adapter foil, and plated-through holes 19, (shown only in Fig. 5), i.e. conducting areas in the adapter foil extending in the direction of the Z-axis, that is perpendicular to the adapter foil 8, so that the test current of the testing device can flow from one contact of the basic grid 3 via the components shown in the drawings, to the associated contact area 13 on the one side of the adapter foil and on to the other contact area 12 on the other side of the adapter foil, and from there to the connecting point 6 of the test specimen 4 to be tested.

With the aid of frame sections 14, 15 and 19' at its edges, the adapter foil 8 can be displaced or elastically elongated /stretched in the direction of its plane by a mechanical adjustment system A - not shown in detail - in order to adjust the position of the lands 12 on the side assigned to the test specimen 4 as required in relation to the test specimen, whose position is set by means of a suitable locating hole and an associated conical pin. Since the test contacts 6 on the test specimen and the corresponding mirror-image lands 12 on the adapter foil 8 are extraordinarily small and can therefore give rise to possible contact faults between the adapter foil and the test specimen due to manufacturing length tolerances between the test specimen and the adapter foil, the entire adapter foil can be displaced or elastically stretched within certain limits in order to achieve the necessary satisfactory contact at all contact points. A tensile force can also be selectively applied to various frame sections 14, 15. Only a very small amount of displacement and/or stretch in the adapter foil is usually necessary in order to achieve complete contact with the printed circuit board to be tested, without therefore the obviously larger and preferably regularly-arranged contact areas 13 on the side of the adapter foil 8 facing away from the test specimen disengaging from the associated conductors 20 or test probes 21 of the adapter arrangement.

In the embodiment of Figs. 1 and 3, the lands 13 of the adapter foil 8 are electrically connected via the conductors 20 of a flat continuous pressure-transmitting part 11 of elastically-compressible, non-conducting elastomer material. These conductors 20 are then in turn in contact with an adapter plate 9 which translates the preferably regular arrangement of conductors 20 or contact areas 13 into the basic grid of the testing device 2 as required, the adapter plate 9 being connected via a so-called active basic grid 18 to the contacts 3 of the basic grid of the testing device. The active basic grid is a conventional component which has spring contacts corresponding to the basic grid of the testing device 2, and provides the necessary contact pressure between the rigid contacts 3 of the testing device and the correspondingly arranged contact areas of the adapter plate 9.

In Fig. 2, a conventional test probe adapter 22 replaces the conductors 20 in the pressure-transmitting part 11, the adapter plate 9 and if necessary the active basic grid 18, inasmuch as it involves spring test probes. In this embodiment, the elastically-compressible pressure-transmitting part 11 (e.g. made of rubber) has holes or channels corresponding to the arrangement of adapter foil lands 13 and the test probes pass through these holes or channels in the pressure-transmitting part 11 and make contact with the lands 13. Here the entire area of the pressure-transmitting part 11 is pressed by the uppermost test probe guide plate of the conventional test probe adapter 22 in the direction of the adapter foil 8, thus producing the necessary elastic pressure force over the entire area of the adapter foil 8. In this case the test probe adapter connects in the known manner the contact areas 13 to the contacts 3 of the testing device and in this way translates - where necessary - from a closely-spaced grid in the adapter foil 8 to the basic grid of the testing device. It is perfectly possible to use a so-called full-grid test probe adapter, i.e. a test probe adapter in which all grid points are occupied by a test probe, even if not all of them are connected to the test specimen via the adapter foil, which gives the advantage that in spite of different adapter foils and test specimens, the same test probe adapter can be used. Examples of conventional test probe adapters are described and claimed in the applicant's EP 26 824 B1, EP 315 707 B1 or EP 215 146, but these are always represented as special/individual adapters and not as full-grid test probe adapters.

The pressure-transmitting part 11 is preferably a rubber mat of sandwich construction, whereby the part lying against the adapter foil 8 is of compressible rubber and the part facing the printed circuit board testing device consists of a dimensionally-stable epoxy resin, for example, so that the pressure-transmitting part 11 is by and large compressible on one side in the vertical direction, i.e. in the direction of the Z-axis, but is dimensionally-stable in the X-Y plane. Such a pressure-transmitting part 11 of the embodiment of Figure 2 can be provided with holes/channels of 10 to 0.5 mm diameter and less, in such a way that a sandwich arrangement of epoxy resin plate/rubber mat/epoxy resin plate is drilled in the clamped state, after which the top epoxy resin plate, which is merely required for the drilling operation, is removed and is not therefore glued to the rubber mat like the bottom epoxy resin plate.

In the embodiment in Figure 1, the pressure-transmitting part 11 has conductors 20 arranged in the grid pattern of the contacts 13 and these are incorporated in the rubber mat and/or the sandwich construction of epoxy resin plate and rubber mat glued to it. As a result, these conductors 20 extend from the top face to the bottom face of this sandwich construction and form lands or contact areas arranged in the grid on the top and bottom faces. Here these conductors 20, which are preferably wires of 0.2 to 0.4 mm diameter, for example, are arranged obliquely to the plane of this pressure-transmitting part. This produces a spring compliance in the lands formed by them on the top and bottom faces in the direction of the Z-axis, i.e. the inclination of these conductors or wires 20 in the pressure-transmitting element 11 provides an electrically-conducting component at specific grid points in the vertical direction of the pressure-transmitting element 11, which does not have the drawbacks of the conventional vertical conducting plates, which have very thin and very closely-spaced, fine gold wires extending perpendicularly to the plane of the plate, and whose spring compliance is merely due to their bending stress.

The conventional test probe adapter 22 shown in Fig. 2 is one such as is more precisely described in the above-mentibned EP 315 707 B1, for instance. But the other conventional test probe adapters can be used. It is essential that the entire area of the uppermost test probe guide plate of the test probe adapter 22 in Fig. 2 makes contact with the lower side of the pressure-transmitting element 11 in Fig. 2 in order to achieve continuous, laminar support of the flexible foil 8 in this way.

In a concrete, preferred embodiment of a printed circuit board of the type described and discussed here, the adapter foil 8 consists of a polyimide material or (not quite so advantageous) an epoxy resin material, and the foils can have a thickness of 0.025 mm or 0.050 mm. Since the test contacts 6 of the printed circuit board 4 to be tested can have a width down to 0.1 mm, with a centre-to-centre distance down to 0.1 mm and less, the correspondingly arranged and formed lands 12 on the adapter foil 8 have a width or a diameter of approximately 0.015 to 0.020 mm, whereby copper with preferably a gold coating is used as the contact material. The lands 13 on the opposite side of the adapter foil have diameters down to about 0.6 mm, and the horizontal displacement or elongation of the adapter foil 8 is typically only 0.2 mm over an overall length of approximately 300 to 500 mm. As a result, any spontaneous deviations in the position of the test contacts 6 or the lands 12 from the reference position, which occur during the manufacture of the printed circuit boards to be tested, or during the manufacture of the adapter foil, can then be compensated very satisfactorily.

The pressure-transmitting part 11 in the embodiment of Fig. 1 consists, in a preferred embodiment, of a rubber mat of approximately 2 to 5 mm thickness, which can for example be glued to a thin epoxy resin plate in order to obtain reasonable stability in the X-Y plane. The conductors 20 in the form of wires are, for example, arranged in a 1.27 mm grid and have a typical thickness of 0.2 to 0.4 mm. These wires can be gold-plated or even gold.

## Claims

1. Printed circuit board testing device with contacts (3) arranged in a pre-determined basic grid pattern, that are connected to a computer (1) and whose number corresponds to at least the highest possible number of test points (6) on the printed circuit board (4) to be tested,
- with a pressure device (10) for the printed circuit board and
- with an adapter arrangement (8, 11 , 9 18 ; 8, 11, 22, 18) for electrically connecting the test specimen-specific test points (6) of the printed circuit board (4) to be tested to the grid-orientated contacts (3) of the basic grid pattern of the printed circuit board testing device (2),
- whereby the adapter arrangement has a flexible adapter foil (8), that carries on the side facing the basic grid pattern preferably regularly-arranged lands (13) and on the side facing the test specimen, test specimen-specific lands (12), that are in direct contact with the test points (6) of the printed circuit board to be tested, whereby the mutually-assigned lands are electrically Interconnected on both sides of the adapter foil by plated-through holes (19) and, if necessary, associated printed conductors (16, 17),
characterized in that, the adapter foil (8) and the printed circuit boards (4) to be tested are retained in the adapter arrangement, with the foil and the circuit board (4) being displaceable relative to each other in or parallel to the plane of the adapter foil (8) to connect the circuit board (4) with the adapter foil in order to adjust the adapter foil (8) as required so that the contact faults which are entirely due to manufacturing length tolerances in the test specimens or adapter foil disappear.

2. Device according to claim 1, characterized in that, the adapter foil (8) is retained in the adapter arrangement and is elastically elongated or stretched in its plane.

3. Device according to claim 1 or 2, characterised in that, the preferably regularly-arranged lands (13) of the adapter foil which face the basic grid pattern, are made considerably larger than the possibly very small and possibly locally very densely arranged test specimen-specific lands (12) on the side of the adapter foil (8) facing the test specimen.

4. Device according to one of the claims 1 to 3, characterised in that, the regularly-arranged lands (13) of the adapter foil which face the basic grid pattern, are arranged in accordance with the basic grid pattern (contacts (3)) of the printed circuit board testing device (2).

5. Device according to one of the claims 1 to 3, characterised in that, the regularly-arranged lands (13) of the adapter foil (8) which face the basic grid pattern, are arranged in accordance with a grid with higher density than that of the basic grid pattern of the printed circuit board testing device (2).

6. Device according to one of the preceding claims, characterised in that, a flat continuous pressure transmitting part (11) of electrically-insulating, elastically-compressible material is arranged on the side of the adapter foil (8) that faces away from the printed circuit board to be tested and is in direct contact with said adapter foil, whereby the pressure-transmitting part is provided, at least partially, with holes/channels (10) corresponding to the preferably regularly-arranged lands (13) of the adapter foil (8).

7. Device according to claim 6, characterised in that, the holes/channels (10) of the pressure-transmitting part (11) is penetrated by conductors (20, 21) that directly or indirectly connect at least partially the preferably regularly-arranged lands (13) of the adapter foil to the grid-orientated contacts (3) of the basic grid pattern of the printed circuit board test device (2).

8. Device according to claim 7, characterised in that, the conductors are test probes (21) of a conventional test probe adapter (22), whose test probe guide plate furthest from the basic grid pattern lies flat in a pressure-transmitting manner against the side of the pressure-transmitting element (11) facing away from the printed circuit board to be tested.

9. Device according to claim 7, characterised in that, the conductors (20) are incorporated into the pressure-transmitting part and extend from the top face to the bottom face of the latter in order to form preferably regularly-arranged lands on the top and bottom faces of the pressure-transmitting part (11).

10. Device according to claim 9, characterised in that, the conductors (20) run obliquely to the top and bottom faces of the pressure-transmitting part (11).

11. Device according to claim 8, 9 or 10, characterised in that, the test probes (21) of the test probe adapter (22) or the conductors (20) of the pressure-transmitting part (11) are connected indirectly or directly to the contacts (3) of the basic grid pattern via a further adapter plate (9) or adapter foil and/or an active basic grid (18).

12. Device according to one of the claims 1 or 2, characterised in that, the adapter foil is retained by frame sections (14, 15) attached to its edge, which can be selectively adjusted, manually or by means of a motor, by a mechanical adjustment system provided on the adapter arrangement or on the printed circuit board test device.

13. Device according to one of the claims 6 to 12, characterised in that, on the side facing away from the printed circuit board to be tested, the flat continuous pressure-transmitting part (11) of electrically-insulating, elastically-compressible material is provided with a layer of a relatively dimensionally-stable material to increase the transverse stability of the pressure-transmitting part.

14. Use of a vertical conducting plate in a printed circuit board testing device according to one of the preceding claims, in the form of a flat continuous mat (11) of electrically-insulating, elastically-compressible material in which conductors that run parallel to each other and extend between the top and bottom faces of the mat, are embedded, characterised in that, the conductors are either in the form of compression springs or essentially straight wires (20) arranged obliquely to the top and bottom faces.

15. Use of a vertical conducting plate according to claim 14, characterised in that, the conductors (20) are arranged in the grid of the adjacent lands (13) or connecting points of the adapter arrangement.

16. Process for adjusting an adapter arrangement for a printed circuit board testing device according to one of the preceding claims 1 to 12, characterised in that, a possible deviation or possible deviations of the test point pattern of the printed circuit board to be tested, from a pre-determined reference value or reference values is determined outside the test device and any necessary correction to the position of the adapter foil is effected in the adapter arrangement manually or by means of a motor, with said correction being carried out by the foil and the circuit board being displaceable relative to each other in or parallel to the plane of the adapter foil to connect the circuit board with the adapter foil in order to adjust the adapter foil as required so that the contact faults which are entirely due to manufacturing length tolerances in the test specimens or adapter foil disappear.

## Patentansprüche

1. Leiterplatten-Prüfvorrichtung mit in einem vorbestimmten Grundraster angeordneten Kontaktelementen (3), die an einen Rechner (1) angeschlossen sind und deren Anzahl mindestens der größtmöglichen Anzahl von Prüfpunkten (6) auf der zu prüfenden Leiterplatte (4) entspricht, mit
- einer Andruckeinrichtung (10) für die Leiterplatte und
- einer Adapteranordnung (, 11, 9, 18; 8, 11, 22, 18) zum elektrischen Verbinden der für den Prüfling (4) spezifischen Prüfpunkte (6) auf diesem mit den rastergerechten Kontaktelementen (3) des Grundrasters der Leiterplatten-Prüfvorrichtung (2), wobei
- die Adapteranordnung eine biegsame Adapterfolie (8) aufweist, die auf der dem Grundraster zugeordneten Seite vorzugsweise regelmäßig angeordnete Kontaktflächen (13) und auf der dem Prüfling zugewandten Seite für den Prüfling spezifische Kontaktflächen (12) trägt, die in direktem Kontakt mit den Prüfpunkten (6) der zu prüfenden Leiterplatte stehen, so daß die einander zugeordneten Kontaktflächen auf den beiden Seiten der Adapterfolie durch durchkontaktierte Löcher (19) und ggf. zugehörige Leiterbahnen (16, 17) elektrisch miteinander verbunden sind,
**dadurch gekennzeichne t**, daß
die Adapterfolie (8) und die zu prüfende Leiterplatte (4) in der Adapteranordnung so festgehalten werden, daß die Folie und die Leiterplatte (4) in oder parallel zur Ebene der Adapterfolie (8) relativ zueinander verschiebbar sind, um die Leiterplatte (4) mit der Adapterfolie so zu verbinden, daß letztere nach Bedarf justiert werden kann, um durch fertigungsbedingte Längentoleranzen verursachte Kontaktierungsfehler im Prüfling oder der Adapterfolie auszugleichen.

2. Vorrichtung nach Anspruch 1, **dadurch gekennzeichnet,** daß die Adapterfolie (8) in der Adapteranordnung festgehalten und in ihrer Ebene elastisch gereckt wird.

3. Vorrichtung nach Anspruch 1 oder 2, **dadurch gekennzeichnet,** daß die dem Grundraster zugewandten, vorzugsweise regelmäßig angeordneten Kontaktflächen (13) der Adapterfolie wesentlich größer ausgeführt sind als die für den Prüfling spezifischen, möglicherweise sehr kleinen und möglicherweise örtlich sehr dicht gedrängten Kontaktflächen (12) auf der dem Prüfling zugewandten Seite der Adapterfolie (8).

4. Vorrichtung nach einem der Ansprüche 1 bis 3, **dadurch gekennzeichnet**, daß die dem Grundraster zugewandten, regelmäßig angeordneten Kontaktflächen (13) der Adapterfolie entsprechend dem Grundraster (Kontaktelemente (3)) der Leiterplatten-Prüfvorrichtung (2) angeordnet sind.

5. Vorrichtung nach einem der Ansprüche 1 bis 3, **dadurch gekennzeichnet,** daß die dem Grundraster zugewandten, regelmäßig angeordneten Kontaktflächen (13) der Adapterfolie entsprechend einem Grundraster höherer Dichte als dem Grundraster der Leiterplatten-Prüfeinrichtung (2) angeordnet sind.

6. Vorrichtung nach einem der vorgehenden Ansprüche, **dadurch gekennzeichnet,** daß ein flaches durchgehendes Druckübertragungsteil (11) aus einem elektrisch isolierenden und elastisch komprimierbaren Werkstoff auf der der zur prüfenden Leiterplatte abgewandten Seite der Adapterfolie (8) angeordnet ist und mit dieser in direkter Berührung steht und daß das Druckübertragungsteil mindestens teilweise mit Löchern/Kanälen (10) entsprechend den vorzugsweise regelmäßig angeordneten Kontaktflächen (13) der Adapterfolie (8) versehen ist.

7. Vorrichtung nach Anspruch 6, **dadurch gekennzeichnet,** daß durch die Löcher/Kanäle (10) des Druckübertragungsteils (11) hindurch Leiter (20, 21) verlaufen, die die vorzugsweise regelmäßig angeordneten Kontaktflächen (13) der Adapterfolie mindestens teilweise mit den rasterorientierten Kontaktelementen (3) des Grundrasters der Leiterplatten-Prüfvorrichtung (2) direkt oder indirekt verbinden.

8. Vorrichtung nach Anspruch 7, **dadurch gekennzeichnet,** daß die Leiter Prüfstifte (21) eines herkömmlichen Prüfstiftadapters (22) sind, dessen vom Grundraster am weitesten entfernte Prüfstift-Führungsplatte auf der von der zu prüfenden Leiterplatte abgewandten Seite des Druckübertragungsteils (11) flächig und druckübertragend aufliegt.

9. Vorrichtung nach Anspruch 7, **dadurch gekennzeichnet**, daß die Leiter (20) in das Druckübertragungsteil eingebettet sind und von der Oberzur Unterseite desselben verlaufen, um auf der Ober- und der Unterseite des Druckübertragungsteils (11) vorzugsweise regelmäßig angeordnete Kontaktflächen zu bilden.

10. Vorrichtung nach Anspruch 9, **dadurch gekennzeichnet,** daß die Leiter (20) schräg von der Ober- zur Unterseite des Druckübertragungsteils (11) verlaufen.

11. Vorrichtung nach Anspruch 8, 9 oder 10, **dadurch gekennzeichnet,** daß die Prüfstifte (21) des Prüfstiftadapters (22) oder die Leiter (20) des Druckübertragungsteils (11) über eine weitere Adapterplatte (9) oder eine Adapterfolie und/oder ein aktives Grundraster (18) mit den Kontaktelementen (3) des Grundrasters direkt oder indirekt verbunden sind.

12. Vorrichtung nach einem der Ansprüche 1 oder 2, **dadurch gekennzeichnet,** daß die Adapterfolie mit an ihre Kante angesetzten Rahmenteilen (14, 15) festgehalten wird, die über eine Verstellmechanik, die auf der Adapteranordnung oder der Leiterplatten-Prüfvorrichtung angeordnet ist, manuell oder motorisch wahlweise verstellbar ist.

13. Vorrichtung nach einem der Ansprüche 6 bis 12, **dadurch gekennzeichnet,** daß auf seiner von der zu prüfenden Leiterplatte abgewandten Seite das flache durchgehende Druckübertragungsteil (11) aus elektrisch isolierendem und elastisch komprimierbarem Werkstoff mit einer Schicht aus einem verhältnismäßig maßhaltigen Werkstoff versehen ist, um die Querstabilität des Druckübertragungsteils zu erhöhen.

14. Verwendung einer vertikalen leitfähigen Platte in einer Leiterplatten-Prüfvorrichtung nach einem der vorgehenden Ansprüche in Form einer flachen durchgehenden Matte (11) aus elektrisch isolierendem und elastisch komprimierbarem Werkstoff mit Leitern, die in die Matte zwischen deren Ober- und der Unterseite parallel zueinander verlaufend eingebettet sind, **dadurch gekennzeichnet,** daß die Leiter in Form entweder von Druckfedern oder von im wesentlichen gradlinigen Drähten (20) vorliegen, die schräg zur Ober- und Unterseite verlaufen.

15. Verwendung einer vertikalen leitfähigen Platte nach Anspruch 14, **dadurch gekennzeichnet,** daß die Leiter (20) im Raster der angrenzenden Kontaktflächen (13) oder Anschlußpunkte der Adapteranordnung angeordnet sind.

16. Verfahren zum Verstellen einer Adapteranordnung für eine Leiterplatten-Prüfvorrichtung nach einem der vorgehenden Ansprüche 1 bis 12, **dadurch gekennzeichnet,** daß man eine oder mehrere mögliche Abweichungen des Prüfpunktmusters auf der zu prüfenden Leiterplatte von einem oder mehreren Bezugswerten außerhalb der Prüfeinrichtung bestimmt und eine erforderliche Korrektur der Lage der Adapterfolie in der Adapteranordnung manuell oder motorisch durchführt, wobei zur Korrektur die Folie und die Leiterplatte in oder parallel zu der Ebene der Adapterfolie relativ zueinander verschiebbar sind, um die Leiterplatte mit der Adapterfolie zu verbinden, um die Adapterfolie nach Bedarf so zu verstellen, daß nur durch fertigungsbedingte Längentoleranzen verursachte Kontaktierungsfehler in den Prüflingen oder der Adapterfolie verschwinden.

## Revendications

1. Appareil de test de cartes de circuit imprimé, ayant des contacts (3) disposés suivant un dessin fondamental prédéterminé de grille, les contacts étant connectés à un ordinateur (1) et étant en nombre correspondant au moins au plus grand nombre possible de points de test (6) de la carte (4) de circuit imprimé à tester, comprenant
- un appareil (10) de pression destiné à exercer une pression sur la carte de circuit imprimé, et
- un ensemble adaptateur (8, 11, 9, 18 ; 8, 11, 22, 18) destiné à connecter électriquement les points de test (6) spécifiques d'une éprouvette de test de carte (4) de circuit imprimé à tester aux contacts (3) orientés suivant la grille du dessin fondamental de grille de l'appareil (2) de test de cartes de circuit imprimé,
l'ensemble adaptateur comportant une feuille souple (8) d'adaptateur qui porte, du côté tourné vers le dessin fondamental de grille, des portées (13) de préférence disposées régulièrement et, du côté tourné vers l'éprouvette de test, des portées (12) spécifiques de l'éprouvette de test, qui sont en contact direct avec les points de test (6) de la carte de circuit imprimé à tester, si bien que les portées affectées mutuellement sont interconnectées électriquement des deux côtés de la feuille d'adaptateur par des trous (19) revêtus à l'intérieur et, le cas échéant, par des conducteurs imprimés associés (16, 17),
caractérisé en ce que la feuille (8) d'adaptateur et la carte (4) de circuit imprimé à tester sont retenues dans l'ensemble adaptateur, la feuille et la carte (4) de circuit pouvant être déplacées l'une part rapport à l'autre dans le plan de la feuille (8) d'adaptateur ou parallèlement à ce plan afin que la carte (4) de circuit soit connectée à la feuille d'adaptateur et permette l'ajustement de la feuille (8) d'adaptateur qui peut être nécessaire pour que les défauts de contact, entièrement dûs aux tolérances de fabrication sur la longueur dans les éprouvettes de test ou la feuille d'adaptateur, disparaissent.

2. Appareil selon la revendication 1, caractérisé en ce que la feuille (8) d'adaptateur est retenue dans l'ensemble adaptateur et est allongée ou étirée élastiquement dans son plan.

3. Appareil selon la revendication 1 ou 2, caractérisé en ce que les portées (13), qui sont de préférence disposées régulièrement sur la feuille d'adaptateur et qui sont tournées vers le dessin fondamental de grille, sont formées afin qu'elles soient bien plus grandes que les portées (12) spécifiques de l'éprouvette de test qui peuvent être très petites et éventuellement placées localement de manière très dense, du côté de la feuille (8) d'adaptateur tournée vers l'éprouvette de test.

4. Appareil selon l'une des revendications 1 à 3, caractérisé en ce que les portées (13) disposées régulièrement sur la feuille d'adaptateur qui sont tournées vers le dessin fondamental de grille sont disposées suivant le dessin fondamental de grille (contact (3)) de l'appareil (2) de test de la carte de circuit imprimé.

5. Appareil selon l'une des revendications 1 à 3, caractérisé en ce que les portées (13) de la feuille (8) d'adaptateur qui sont disposées régulièrement, tournées vers le dessin fondamental de grille, sont disposées suivant une grille de densité supérieure à celle du dessin fondamental de grille de l'appareil (2) de test de la carte de circuit imprimé.

6. Appareil selon l'une des revendications précédentes, caractérisé en ce qu'une partie plate et continue (11) de transmission de pression d'un matériau d'isolement électrique compressible élastiquement est disposée du côté de la feuille (8) d'adaptateur opposé à celui de la carte de circuit imprimé à tester et est en contact direct avec la feuille d'adaptateur, si bien que la partie de transmission de pression comporte, au moins partiellement, des trous-canaux (10) correspondant aux portées (13) de la feuille (8) d'adaptateur qui sont disposées de préférence régulièrement.

7. Appareil selon la revendication 6, caractérisé en ce que les trous-canaux (10) de la partie (11) de transmission de pression sont occupés par des conducteurs (20, 21) qui assurent une connexion directe ou indirecte au moins partielle des portées (13) de la feuille d'adaptateur qui sont disposées de préférence régulièrement aux contacts (3) orientés suivant une grille appartenant au dessin fondamental de grille de l'appareil (2) de test de carte de circuit imprimé.

8. Appareil selon la revendication 7, caractérisé en ce que les conducteurs sont des sondes (21) de test d'un adaptateur classique (22) à sondes de test dont la plaque de guidage de sondes de test la plus éloignée du dessin fondamental de grille est disposée à plat d'une manière permettant l'application d'une pression à la face de l'élément (11) de transmission de pression tournée du côté opposé à la carte du circuit imprimé à tester.

9. Appareil selon la revendication 7, caractérisé en ce que les conducteurs (20) sont incorporés à la partie de transmission de pression et sont disposés de la face supérieure à la face inférieure de cette partie afin qu'ils forment des portées disposées de préférence régulièrement aux faces supérieure et inférieure de la partie (11) de transmission de pression.

10. Appareil selon la revendication 9, caractérisé en ce que les conducteurs (20) sont placés obliquement vers les faces supérieure et inférieure de la partie (11) de transmission de pression.

11. Appareil selon la revendication 8, 9 ou 10, caractérisé en ce que les sondes (21) de test de l'adaptateur (22) à sonde de test ou les conducteurs (20) de la partie (11) de transmission de pression sont connectés directement ou indirectement aux contacts (3) du dessin fondamental de grille par l'intermédiaire d'une plaque supplémentaire (9) d'adaptateur ou d'une feuille d'adaptateur et/ou d'une grille fondamentale active (18).

12. Appareil selon l'une des revendications i et 2, caractérisé en ce que la feuille d'adaptateur est retenue par des tronçons (14, 15) de cadre fixés à son bord et qui peuvent être ajustés sélectivement, manuellement ou à l'aide d'un moteur, par un système d'ajustement mécanique placé sur l'ensemble adaptateur ou sur l'appareil de test de carte de circuit imprimé.

13. Appareil selon l'une des revendications 6 à 12, caractérisé en ce que, du côté opposé à la carte de circuit imprimé à tester, la partie plate et continue (11) de transmission de pression d'un matériau isolant de l'électricité et compressible élastiquement comporte une couche d'un matériau possédant une stabilité dimensionnelle relative afin que la stabilité transversale de la partie de transmission de pression soit accrue.

14. Application d'une plaque conductrice verticale à un appareil de test de cartes de circuit imprimé selon l'une des revendications précédentes, sous forme d'une nappe plate et continue (11) d'un matériau isolant de l'électricité et compressible élastiquement, dans laquelle sont enrobés des conducteurs placés parallèlement les uns aux autres et disposés entre les faces supérieure et inférieure de la nappe, caractérisée en ce que les conducteurs sont soit sous forme de ressorts de compression, soit sous forme de fils métalliques (20) essentiellement rectilignes placés obliquement par rapport aux faces supérieure et inférieure.

15. Application d'une plaque conductrice verticale selon la revendication 14, caractérisée en ce que les conducteurs (20) sont disposés dans la grille des portées adjacentes (13) ou des points de connexion de l'ensemble adaptateur.

16. Procédé d'ajustement d'un ensemble adaptateur destiné à un appareil de test de cartes de circuit imprimé selon l'une des revendications précédentes 1 à 12, caractérisé en ce qu'un ou plusieurs écarts possibles du dessin de points de test de la carte de circuit imprimé à tester par rapport à une ou plusieurs valeurs prédéterminées de référence sont déterminés en dehors de l'appareil de test, et une correction éventuellement nécessaire de la position de la feuille d'adaptateur est réalisée manuellement ou à l'aide d'un moteur dans l'ensemble adaptateur, la correction étant réalisée par déplacement de la feuille ou de la carte de circuit l'une par rapport à l'autre, dans le plan de la feuille d'adaptateur ou parallèlement à ce plan, afin que la carte de circuit soit connectée à la feuille d'adaptateur et que la feuille d'adaptateur soit ajustée de manière que les défauts des contacts, entièrement dûs aux tolérances de fabrication sur les longueurs dans les éprouvettes de test ou la feuille d'adaptateur, disparaissent.
